# EUROPEAN PATENT APPLICATION

(11) **EP 4 580 374 A1**
(43) Date of publication of application: **02.07.2025**
(21) Application number: 24217947.1
(22) Date of filing: 06.12.2024
(51) Int. Cl.: H10K 59/131

(54) **DISPLAY DEVICE**

(30) Priority: 28.12.2023 KR 20230195617
(71) Applicant: LG Display Co., Ltd., Seoul 07336 (KR)
(72) Inventor: SHIM, JaeMin, 10845 Gyeonggi-do (KR); KIM, Euijun, 10845 Gyeonggi-do (KR); LEE, GeunGi, 10845 Gyeonggi-do (KR); KIM, WooSang, 10845 Gyeonggi-do (KR); UHM, Mihee, 10845 Gyeonggi-do (KR); JEON, Seoil, 10845 Gyeonggi-do (KR)
(74) Representative: Ter Meer Steinmeister & Partner

(57) **Abstract**

The present application relates to a display device. The display device includes a display area (DA) where a plurality of pixels are disposed to display an image, a non-display area (NDA) disposed outside the display area (DA), the non-display area (NDA) including a pad area (PA), a power shorting bar (610) disposed at one side of the display area (DA), in the non-display area (NDA), a power pad (PAD2) disposed in the pad area (PA), and a bottleneck portion (620) connecting the power shorting bar (610) to a power pad (PAD2). The power shorting bar (610) has a mesh structure where a plurality of first power lines (612) extending in a first direction (Y) and a plurality of second power lines (614) extending in a second direction (X) are connected to each other.

## Description

### BACKGROUND

### Technical Field

The present disclosure relates to a display device, and more particularly, for example, without limitation, to a display device which are capable of decreasing a concentration of a current in an element to which a source voltage is applied.

### Discussion of the Related Art

With advancement in information-oriented societies, demands for display devices that display an image have increased in various forms. Various types of display devices such as a liquid crystal display (LCD) device, a plasma display panel (PDP) device, a Quantum dot Light Emitting Display (QLED), and an organic light emitting display (OLED) device have been widely utilized.

The description provided in the discussion of the related art section should not be assumed to be prior art merely because it is mentioned in or associated with that section. The discussion of the related art section may include information that describes one or more aspects of the subject technology, and the description in this section does not limit the invention.

### SUMMARY

Display devices include two substrates, and a plurality of pixels can be provided between the two substrates to display an image. The pixels can be driven with power supplied through power lines. A high voltage can be applied to the power lines, and thus, when a current concentrates in a certain region, much heat can occur. Due to this, a power line can be damaged, or static electricity can occur between the power line and a peripheral signal line, a burst phenomenon can occur.

An aspect of the present disclosure is directed to providing a display device which are capable of decreasing a concentration of a current in an element to which a source voltage is applied.

Another aspect of the present disclosure is directed to providing a display device, which are capable of realizing ESG (Environment/Social/Governance) by reducing the generation of greenhouse gases due to the manufacturing process for producing the display device.

Additional advantages and features of the disclosure will be set forth in part in the description which follows and in part will become apparent to those having ordinary skill in the art upon examination of the following or can be learned from practice of the disclosure. The objectives and other advantages of the disclosure can be realized and attained by the structure particularly pointed out in the written description and claims hereof as well as the appended drawings.

One or more of the above identified objects are solved by the features of the independent claim.

To achieve these and other advantages and in accordance with the purpose of the disclosure, as embodied and broadly described herein, there is provided a display device including a display area where (or: in which) a plurality of pixels are disposed to display an image (that is, the device comprises a plurality of pixels disposed in the display area), a non-display area disposed outside the display area, the non-display area including a pad area, a power shorting bar disposed at one side of the display area, in the non-display area, a power pad disposed in the pad area, and a bottleneck portion connecting the power shorting bar to a (or the) power pad. The power shorting bar has a mesh structure where (that is, in which) a plurality of first power lines extending in a first direction and a plurality of second power lines extending in a second direction are connected to each other. That is, the mesh structure of the power shorting bar comprises the plurality of first power lines extending in a first direction and the plurality of second power lines extending in a second direction.

Also, there is provided a display device including a display area where a plurality of pixels are disposed to display an image, a non-display area disposed outside the display area, the non-display area including a pad area, a power shorting bar disposed at one side of the display area, in the non-display area, a power pad disposed in the pad area, and a bottleneck portion connecting the power shorting bar to a (or the) power pad. The power shorting bar has a mesh structure where a plurality of first power lines extending in a first direction and a plurality of second power lines extending in a second direction are connected to each other. Widths of the plurality of first power lines and the plurality of second power lines are differently designed.

One or more of the above-described aspects may include one or more of the following features:

The display device may comprise a bottleneck portion connecting the power shorting bar to the power pad. That is, the power shorting bar may be connected to the power pad via a bottleneck portion. In other words, the display device may comprise a connection connecting the power shorting bar to the power pad, said connection comprising a bottleneck portion. And the power shorting bar may be connected to the power pad via the bottleneck portion of the connection. In other words, the bottleneck portion may form a bottleneck of the connection.

The first direction may be a direction along said one side of the display area. The second direction may be a direction across the first direction, in particular, a direction perpendicular to the first direction.

The bottleneck portion may contact the power shorting bar at one side thereof and may contact the power pad at the other side thereof. The power shorting bar, the bottleneck portion, and the power pad may be formed of the same material and/or in the same layer. That is, the power shorting bar, the bottleneck portion, and the power pad may be provided as one body, without being limited thereto.

The bottleneck portion may be formed to have a width which is less than a width of the power shorting bar.

The bottleneck portion may form a bottleneck of the interconnected (electrically connected) power shorting bar and bottleneck portion. In particular, a width of the power shorting bar and/or of the bottleneck portion may first decrease and may then increase along the connection of the power shorting bar to the power pad, in the bottleneck portion. In other words, along the connection of the power shorting bar to the power pad, the bottleneck portion may have a portion (an inflow portion) that has a (minimum) width which is smaller than a (maximum) width of the power shorting bar and/or smaller than a width of a portion (a connection portion of the bottleneck portion) contacting the power pad.

The bottleneck portion may include an inflow portion contacting the power shorting bar, and/or a connection portion contacting the power pad. The inflow portion may form a bottleneck of the power shorting bar and bottleneck portion connected to each other. In particular, a width of the power shorting bar and of the bottleneck portion may first decrease and may then increase along the connection of the power shorting bar to connection portion, in the inflow portion. In particular, along the connection (or path) of the power shorting bar to the power pad, the inflow portion may have a (minimum) width (a width at some portion of the inflow portion), said width being smaller than a width of the power shorting bar and/or smaller than a (maximum and/or minimum) width of the connection portion.

The display device may comprise a plurality of power pads disposed in the pad area. The bottleneck portion may be provided in plurality. That is, the display device may comprise a plurality of bottleneck portions. Each bottleneck portion may connect the power shorting bar to at least one of the power pads. The plurality of bottleneck portions may be respectively connected to a plurality of power pads. The plurality of bottleneck portions may be disposed apart from one another in the second direction (for example, the X-axis direction). Each bottleneck portion may connect the power shorting bar to two or more of the power pads.

The power shorting bar may have a straight side contacting the bottleneck portion. The power shorting bar may have a rectangular shape.

The power shorting bar may be a bar electrically connecting (shorting) a plurality of common power lines extending (up) to the non-display area from the display area. The plurality of common power lines may extend in the first direction. The power shorting bar may have its main extension in the second direction. The power shorting bar may have its main extension along said one side of the display area.

The plurality of second power lines may include at least two second power lines the widths of which are different from each other.

The plurality of second power lines may have different widths.

Herein, a width of a second power line may be a width in the first direction.

A second power line having a first separation distance from the bottleneck portion (in particular, a first separation distance in the first direction) may have a width which is less than a width of a second power line having a second separation distance from the bottleneck portion (in particular, a second separation distance in the first direction). The first separation distance may be less than the second separation distance.

The plurality of second power lines may have a width (for example, a thickness in the first direction) which increases progressively (or gradually and/or progressively) in a direction distancing from the bottleneck portion (or a direction of increasing distance from the bottleneck portion). In particular, the plurality of second power lines may have respective widths that gradually (and/or progressively) increase in a direction distancing from the bottleneck portion (a direction that may be parallel to the first direction); that is, the widths gradually (and/or progressively) increase with increasing distance (in the first direction) from the bottleneck portion.

In embodiments, the bottleneck portion may contact some of the plurality of first power lines and does not contact the other first power lines.

Herein, when it is said that a component "contacts" another component, this may include that the component directly contacts the other component. For example, in embodiments, the bottleneck portion may directly contact some of the plurality of first power lines and/or may not contact the other first power lines. For example, the other first power lines may be connected to the bottleneck portion through at least one of the second power lines.

At least some of the plurality of first power lines may have different widths. The plurality of first power lines may include at least two first power lines the widths of which are different from each other. Herein, a width of a first power line may be a width in the second direction.

The plurality of first power lines may be grouped into a first group which contacts the bottleneck portion at one end thereof (that is, at one end of bottleneck portion) and a second group which does not contact the bottleneck portion at one end thereof. First power lines (that is, at least some first power lines) included in the second group may have a width which differs from a width of at least one of first power lines included in the first group. The first power lines of the second group may all have a same width.

The first power lines included in the second group may have a width which is less than a width of at least one of the first power lines included in the first group. In other words, at least one of the first power lines included in the first group may have a width that is larger than a width of the first power lines included in the second group (in particular, a width of each of the first power lines included in the second group).

The first power lines included in the first group may be grouped into a first subgroup provided in a first area, a second subgroup provided in a second area disposed at one side of the first area, and a third subgroup provided in a third region (or third area) disposed at the other side of the first area. First power lines included in the first subgroup may have a width which differs from a width of first power lines included in the second subgroup and the third subgroup. Herein, the third region may be also termed a third area. The first power lines of the second subgroup may all have a same width. The first power lines of the first and third subgroups may all have a same width.

The second subgroup may comprise a first power line (a left outermost first power line of the first group), disposed at a left outermost portion, of the first power lines included in the first group. The third subgroup may comprise a first power line (a right outermost first power line of the first group), disposed at a right outermost portion, of the first power lines included in the first group. Herein, "left" and "right" may refer to directions parallel to the second direction, in particular, in a front view of the display device or display area (that is, when looking at the display area to view a displayed image).

The first power lines included in the first subgroup may have a width which is greater than a width of the first power lines included in the second subgroup and the third subgroup.

The first power lines included in the second subgroup and the third subgroup may have the same width as a width of the first power lines included in the second group.

The bottleneck portion may comprise an inflow portion contacting the power shorting bar. In particular, the bottleneck portion may comprise an inflow portion contacting the power shorting bar to allow a current to flow in (in particular, into the bottleneck portion) through the inflow portion. In particular, the bottleneck portion may comprise an inflow portion contacting the power shorting bar and/or configured to allow a current to flow in through the inflow portion.

The inflow portion may contact some of the plurality of first power lines. A current may flow in from the first power lines contacting the inflow portion. In particular, the inflow portion may be configured to allow a current to flow in (in particular, into the bottleneck portion) from the first power lines contacting the inflow portion.

The inflow portion may contact a partial region of an uppermost second power line of the plurality of second power lines. A current may flow in from the uppermost second power line contacting the inflow portion. In particular, the inflow portion may be configured to allow a current to flow in (in particular, into the bottleneck portion) from the uppermost second power line contacting the inflow portion. Herein, "upper" or "uppermost" may refer to a direction parallel to the first direction, in particular, in a front view of the display device or display area (that is, when looking at the display area to view a displayed image). In particular, said one side of the display area at which side the power shorting bar is disposed may be an upper side of the display area. That is, the power shorting bar may be disposed at an upper side of the display area, in the non-display area.

The inflow portion may have a constant width.

The inflow portion may comprise a region or area (a first region or first area) where a width decreases progressively (or gradually and/or progressively) toward the power pad from a side contacting the power shorting bar. Herein, a width of the inflow region, or a width of the connection portion, or a width of the bottleneck portion may refer to a width direction parallel to the second direction.

The inflow portion may comprise a concave portion concavely formed at at least one side of the inflow portion to face a center line of the bottleneck portion. In other words, the inflow portion may comprise a concave portion concavely formed at at least one side of the inflow portion with respect to a center line of the bottleneck portion. The center line may be a center line in the first direction. The inflow portion may comprise a concave portion concavely formed at at least one side of the inflow portion with respect to the first direction. In particular, the concave portion may be formed concavely at a left side and/or at a right side of the concave portion. The center line may be defined with respect to the minimum width and/or maximum width of the bottleneck portion.

The concave portion may comprise a streamlined shape (or a smooth shape) or a curved shape.

The display device may further comprise a plurality of common power lines. The common power lines may be extending in the first direction up to the non-display area from the display area, one end of each of the plurality of common power lines being connected to the power shorting bar. A distance between adjacent first power lines may be less than or may be similar or equal to a distance between adjacent common power lines.

The display area may comprise transmissive areas transmitting external light (or: transmissive areas configured for transmitting external light) and a non-transmissive area between adjacent transmissive areas. Each of the plurality of common power lines may be disposed in a (or the) non-transmissive area.

For example, the transmissive area may be an area where a light transmittance is greater than α%, and the non-transmissive area NTA may be an area where a light transmittance is less than β%. Here, α may be a value which is greater than β.

The display device may further comprise a light emitting device (or at least one light emitting device). Each of the plurality of pixels may comprise at least one light emitting device. Each pixel may comprise subpixels. Each subpixel may comprise a light emitting device. The light emitting device may include an anode electrode, an emission layer, and a cathode electrode. The light emitting device may be provided (that is, disposed) in the non-transmissive area. Each of the plurality of common power lines may transfer (or may be configured or arranged for transferring) a source voltage to the cathode electrode of the (at least one) light emitting device.

The plurality of common power lines may be connected (or respectively connected) to the plurality of first power lines of the power shorting bar.

The plurality of common power lines may be provided (disposed) in a layer which differs from (a layer of) the plurality of first power lines of the power shorting bar. That is, a layer in which the plurality of common power lines may be provided may differ from a layer (or layers) in which the plurality of first power lines of the power shorting bar is provided. Each of the plurality of common power lines may be connected to a corresponding first power line of the plurality of first power lines of the power shorting bar, in particular through a contact hole.

It is to be understood that both the foregoing general description and the following detailed description of the present disclosure are example, and are intended to provide further explanation of the disclosure as claimed.

### BRIEF DESCRIPTION OF THE DRAWINGS

The accompanying drawings, which are included to provide a further understanding of the present disclosure and are incorporated in and constitute a part of the present disclosure, illustrate embodiments of the present disclosure and together with the description serve to explain the principles and examples of the present disclosure.
FIG. 1 is a perspective view schematically illustrating a display device according to an example embodiment of the present disclosure.
FIG. 2 is a plan view schematically illustrating a display panel according to an example embodiment of the present disclosure.
FIG. 3 is a plan view illustrating an example of a subpixel included in a display panel according to an example embodiment of the present disclosure.
FIG. 4 is a circuit diagram illustrating an example of the subpixel of FIG. 3.
FIG. 5 is a cross-sectional view illustrating an example of elements disposed in a non-transmissive area and a transmissive area of FIG. 3.
FIG. 6 is a plan view schematically illustrating a power shorting bar and a bottleneck portion according to an example embodiment of the present disclosure.
FIG. 7 is an enlarged view of a region A of FIG. 6.
FIG. 8 is a cross-sectional view illustrating an example of a stack structure of a power shorting bar and a pixel power line.
FIG. 9 is a diagram illustrating a flow of a current in a power shorting bar and a pixel power line according to an example embodiment of the present disclosure.
FIG. 10 is a diagram illustrating an example of a flow of a current when a first power line and a second power line have a certain width.
FIG. 11 is a diagram illustrating an example of a flow of a current in a first power line and a second power line according to an example embodiment of the present disclosure.
FIG. 12 is a diagram illustrating an example of a flow of a current when an inflow portion of a bottleneck portion has a certain width.
FIG. 13 is a diagram illustrating an example of a flow of a current in an inflow portion of a bottleneck portion according to an example embodiment of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction thereof may be exaggerated for clarity, illustration, and convenience.

### DETAILED DESCRIPTION OF THE DISCLOSURE

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure, and implementation methods thereof will be clarified through following embodiments described with reference to the accompanying drawings. The present disclosure can, however, be embodied in different forms and should not be construed as limited to the example embodiments set forth herein. Rather, these embodiments are provided so that this disclosure will be thorough and complete, and will fully convey the scope of the present disclosure to those skilled in the art. Furthermore, the present disclosure is only defined by scopes of claims.

A shape (e.g., sizes, lengths, widths, heights, thicknesses, locations, radii, diameters, and areas), a ratio, an angle, and a number disclosed in the drawings for describing embodiments of the present disclosure are merely an example, and thus the present disclosure is not limited to the illustrated details. Like reference numerals refer to like elements throughout. In the following description, when the detailed description of the relevant known technology is determined to unnecessarily obscure the important point of the present disclosure, the detailed description will be omitted or briefly given. In a case where "comprise," "have," "include" "contain," "constitute," "make up of," and "formed of," described in the present disclosure are used, another part can be added unless "only" is used. The terms of a singular form can include plural forms unless referred to the contrary.

In analyzing a component, an error range is interpreted as being included even when there is no explicit description

In construing an element, the element is construed as including an error range although there is no explicit description.

In describing a positional relationship, for example, when a position relation between two parts is described as "on", "over", "under", and "next", one or more other parts can be disposed between the two parts unless "just" or "direct" is used. For example, where an element or layer is disposed "on" another element or layer, a third layer or element may be interposed therebetween.

The terms, such as "below," "lower," "above," "upper" and the like, may be used herein to describe a relationship between element(s) or item(s) as illustrated in the drawings. It will be understood that the terms are spatially relative and based on the orientation depicted in the drawings.

In describing a temporal relationship, for example, when a temporal precedence relationship is described such as "after", "following", "next", "before", etc., it can include cases that are not consecutive unless "immediately" or "directly" are used.

It will be understood that, although the terms "first," "second," etc. can be used herein to describe various elements, these elements should not be limited by these terms. These terms are only used to distinguish one element from another. For example, a first element could be termed a second element, and, similarly, a second element could be termed a first element, without departing from the scope of the present disclosure.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various embodiments of the present disclosure can be partially or totally coupled to or combined with each other, and can be variously inter-operated and driven technically. The example embodiments of the present disclosure can be carried out independently from each other or can be carried out together with a co-dependent relationship.

Hereinafter, with reference to the accompanying drawings, one example of a display device according to the present disclosure is described. In assigning reference numerals to the components in each drawing, the same component can have the same numeral as far as possible, even if it is shown in different drawings. In addition, when the detailed description of the relevant known technology is determined to unnecessarily obscure the important point of the present disclosure, the detailed description will be omitted or briefly given.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Hereinafter, embodiments of the present disclosure will be described in detail with reference to the accompanying drawings. The scales of the components shown in the drawings have different scales from the actual ones for convenience of explanation, and thus are not limited to the scales shown in the drawings.

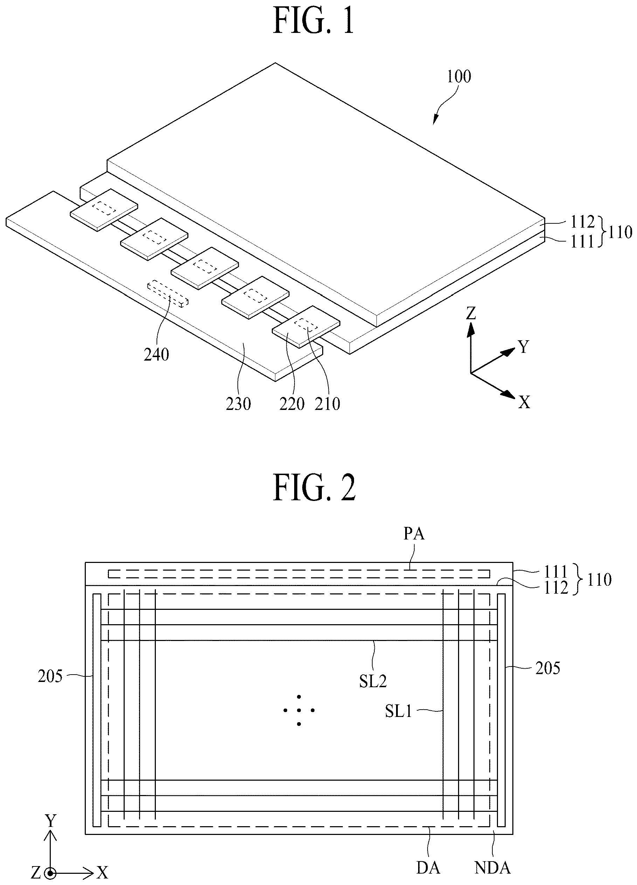

FIG. 1 is a perspective view schematically illustrating a display device 100 according to an example embodiment of the present disclosure. FIG. 2 is a plan view schematically illustrating a display panel according to an example embodiment of the present disclosure.

Herein, an X axis can represent a direction parallel to a scan line, a Y axis can represent a direction parallel to a data line, and a Z axis can represent a height direction of the display device 100.

The display device 100 according to an example embodiment of the present disclosure can be mainly described as being implemented as an organic light emitting display, but is not limited thereto and can be implemented as a liquid crystal display (LCD), a plasma display panel (PDP), a quantum dot light emitting display (QLED), a micro LED (Micro Light Emitting Diode) display device, or an electrophoresis display.

Referring to FIGS. 1 and 2, the display device 100 according to an example embodiment of the present disclosure can include a display panel 110, a source driving integrated circuit (IC) 210, a flexible film 220, a circuit board 230, and a timing controller 240.

The display panel 110 can include a first substrate 111 and a second substrate 112 facing each other. The second substrate 112 can be an encapsulation substrate. The first substrate 111 can be a plastic film, a glass substrate, or a silicon wafer substrate which is formed by using a semiconductor process. The second substrate 112 can be a plastic film, a glass substrate, or an encapsulation film. The first substrate 111 and the second substrate 112 can include a transparent material.

The display panel 110 can be divided into a display area DA where pixels are provided to display an image and a non-display area NDA which does not display an image. The non-display area NDA may refer to an area outside of the display area DA. Several types of signal lines may be disposed in the display area DA, and several types of driving circuits may be connected thereto.

First signal lines SL1, second signal lines SL2, and subpixels can be provided in the display area DA, and a pad area PA where pads are disposed and at least one scan driver 205 can be provided in the non-display area NDA.

The first signal lines SL1 can extend in a first direction (for example, a Y-axis direction) and can intersect with the second signal lines SL2 in the display area DA, without being limited thereto. The first signal lines SL1 can include a pixel power line, a data line, and a common power line. In an example embodiment, the first signal lines SL1 can further include a reference line.

The pixel power line can transfer a first source voltage to a driving transistor of each of the plurality of subpixels. The common power line can transfer a second source voltage to a cathode electrode of each of the plurality of subpixels. For example, the second source voltage can be a common power which is supplied to the plurality of subpixels in common.

The reference line can transfer an initialization voltage (or a reference voltage) to the driving transistor of each of the plurality of subpixels. Data lines can respectively transfer data voltages to the plurality of subpixels.

The second signal lines SL2 can extend in a second direction (for example, an X-axis direction) and can intersect with the first signal lines SL1 in the display area DA, without being limited thereto. The second signal lines SL2 can include a scan line. The scan line can transfer a scan signal to the plurality of subpixels. Alternatively, the first signal lines SL1 can extend in the second direction (for example, an X-axis direction), and the second signal lines SL2 can extend in the first direction (for example, a Y-axis direction).

The subpixels can be provided in a region where the first signal line SL1 is provided or a region where the first signal line SL1 intersects with the second signal line SL2 and can emit certain light to display an image.

A plurality of pads can be disposed in the pad area PA. A size of the first substrate 111 can be greater than that of the second substrate 112, and thus, a portion of the first substrate 111 can be exposed without being covered by the second substrate 112. Pads such as power pads and data pads can be provided in a portion of the first substrate 111 which is exposed without being covered by the second substrate 112.

The scan driver 205 can be connected to a scan line (which may be referred to as gate line) and can supply scan signals (which may be referred to as gate signals). The scan driver 205 can be formed as a gate driver in panel (GIP) type in the non-display area NDA outside one side or both sides of the display area DA of the display panel 110, without being limited thereto. Alternatively, the scan driver 205 can be manufactured as a driving chip and can be mounted on a flexible film and can be attached to the non-display area NDA outside the one side or the both sides of the display area DA of the display panel 110. Also, the scan driver 205 may be disposed in the display area DA of the display panel 110.

The source driving IC 210 can receive digital video data and a data control signal from the timing controller 240. The source driving IC 210 can convert the digital video data into analog data voltages to supply to data lines, based on the data control signal. In a case where the source driving IC 210 is manufactured as a driving chip, the source driving IC 210 can be mounted on the flexible film 220 as a chip on film (COF) type or a chip on plastic (COP) type. The timing controller 240 may be implemented with various circuits or electronic components such as an integrated circuit (IC), a field programmable gate array (FPGA), an application specific integrated circuit (ASIC), a processor, and/or the like, without being limited thereto.

Lines connecting the pads to the source driving IC 210 and lines connecting the pads to lines of the circuit board 230 can be formed in the flexible film 220. The flexible film 220 can be attached to the pads by using an anisotropic conductive film, and thus, the pads can be connected to the lines of the flexible film 220.

The circuit board 230 can be attached to flexible films 220. A plurality of circuits implemented as driving chips can be mounted on the circuit board 230. For example, the timing controller 240 can be mounted on the circuit board 230. The circuit board 230 can be a printed circuit board (PCB) or a flexible printed circuit board (FPCB), without being limited thereto.

The timing controller 240 can receive the digital video data and the timing signal from an external system board. The timing controller 240 can electrically connect to the scan driver 205 and the source driving ICs 210. The timing controller 240 can generate a scan control signal for controlling an operation timing of the scan driver 205 and a data control signal for controlling source driving ICs 210, based on the timing signal. The timing controller 240 can supply the scan control signal to the scan driver 205 and can supply the data control signal to the source driving ICs 210 via one or more predefined interfaces. For example, such interfaces may include, a low voltage differential signaling (LVDS) interface, an embedded clock point-point interface (EPI), a serial peripheral interface (SPI), and the like.

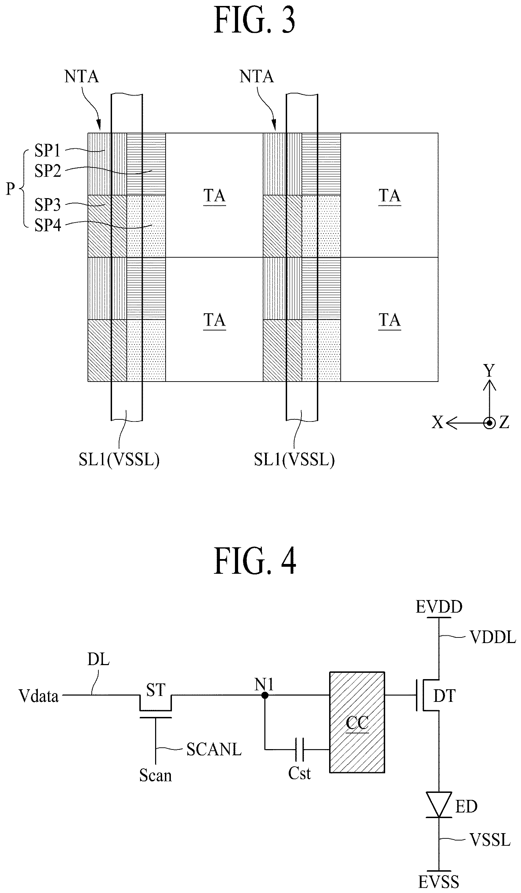

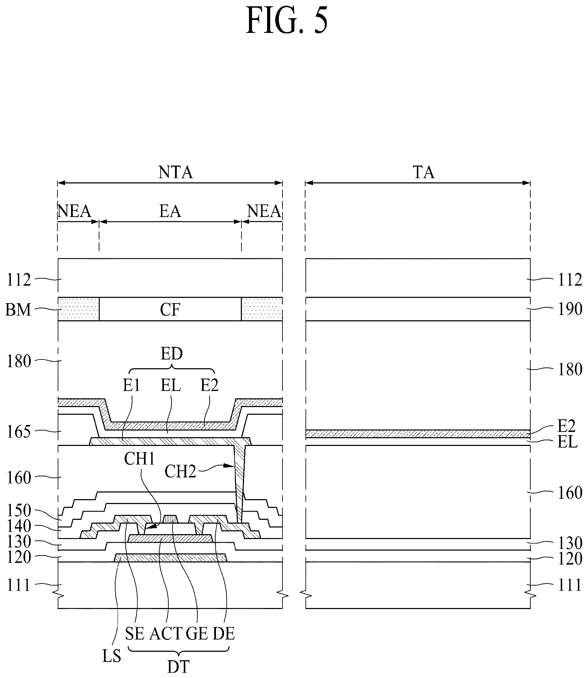

FIG. 3 is a plan view illustrating an example of a subpixel included in a display panel 110 according to an example embodiment of the present disclosure. FIG. 4 is a circuit diagram illustrating an example of the subpixel of FIG. 3. FIG. 5 is a cross-sectional view illustrating an example of elements disposed in a non-transmissive area and a transmissive area of FIG. 3.

The display panel 110 according to an example embodiment of the present disclosure can include the display area DA and the non-display area NDA (see FIG. 2). The display area DA can include a first area where a plurality of subpixels are disposed and a second area where a plurality of subpixels are not disposed. For example, the display area DA, as illustrated in FIG. 3, can include the first area NTA where a plurality of subpixels SP1 to SP4 are disposed and the second area TA where a plurality of subpixels SP1 to SP4 are not disposed. The first area NTA can be a non-transmissive area which does not transmit the most of light incident from the outside, and the second area TA can be a transmissive area which transmits the most of light incident from the outside.

For example, the transmissive area TA can be an area where a light transmittance is greater than α%, and the non-transmissive area NTA can be an area where a light transmittance is less than β%. Here, α can be a value which is greater than β. The display panel 110 can enable a thing or a background disposed at a rear surface of the display panel 110 to be seen, based on a plurality of transmissive areas TA.

The plurality of subpixels SP1 to SP4, a plurality of circuit devices, and a plurality of signal lines SL1 and SL2 can be disposed in the non-transmissive area NTA and may not transmit (that is, may be configured to not transmit) the most of light incident from the outside, without being limited thereto.

The plurality of signal lines can include first signal lines SL1 and second signal lines SL2. The first signal lines SL1 can extend in a first direction (for example, a Y-axis direction) in the non-transmissive area NTA. The first signal lines SL1 can include a pixel power line VDDL, a data line DL, and a common power line VSSL, without being limited thereto. In an example embodiment, the first signal lines SL1 can further include a reference line.

The pixel power line VDDL can transfer a first source voltage to a driving transistor of each of the plurality of subpixels SP1 to SP4. The common power line VSSL can transfer a second source voltage to a cathode electrode of each of the plurality of subpixels SP1 to SP4. For example, the second source voltage can be a common power which is supplied to the plurality of subpixels SP1 to SP4 in common. Also, the common power line VSSL can be spaced apart from the pixel power line VDDL with a transmissive area TA therebetween.

The reference line can transfer an initialization voltage (or a reference voltage) to the driving transistor of each of the plurality of subpixels SP1 to SP4. Data lines DL can respectively transfer data voltages to the plurality of subpixels SP1 to SP4.

The second signal lines SL2 can extend in the second direction (for example, the X-axis direction) in the non-transmissive area NTA, without being limited thereto. The second signal line SL2 can intersect with the first signal lines SL1. The second signal line SL2 can include a scan line SCANL. The scan line SCANL can transfer a scan signal to the plurality of subpixels SP1 to SP4.

Each of the subpixels SP1 to SP4 can be included in the non-transmissive area NTA and can emit light to display an image.

The subpixels SP1 to SP4 can each be one of a first subpixel SP1 emitting a first color light, a second subpixel SP2 emitting a second light, a third subpixel SP3 emitting a third color light, and a fourth subpixel SP4 emitting a fourth color light, but are not limited thereto. For example, the subpixels SP1 to SP4 can each be one of a first subpixel SP1 emitting red light, a second subpixel SP2 emitting green light, a third subpixel SP3 emitting blue light, and a fourth subpixel SP4 emitting white light, but are not limited thereto. Other subpixels emitting light of a different color such as cyan, magenta, or yellow, etc. are also possible. A unit pixel P can include two or more subpixels SP1 to SP4. For example, the unit pixel P can include the first subpixel SP1, the second subpixel SP2, the third subpixel SP3, and the fourth subpixel SP4. As another example, one unit pixel P can include the first subpixel SP1 and the second subpixel SP2, and the other unit pixel P can include the second subpixel SP2 and the third subpixel SP3, without being limited thereto. The arrangement order of the subpixels SP1 to SP4 can be variously changed.

Each of the first subpixel SP1, the second subpixel SP2, the third subpixel SP3, and the fourth subpixel SP4 can include a circuit device and a light emitting device. Referring to FIG. 4, each of the subpixels SP1 to SP4 can have a 2T(Transistor)1C(Capacitor) structure which includes two transistors DT and ST and one capacitor Cst, but is not limited thereto. Each of the subpixels SP1 to SP4 can further include a compensation circuit CC. For example, Each of the subpixels SP1 to SP4 can have various structures such as 3T1C, 4T1C, 4T2C, 5T1C, 5T2C, 6T1C, 6T2C, 7T1C, and 7T2C, and so on.

Each of the transistors DT and ST of each of the subpixels SP1 to SP4 can include a gate electrode, a source electrode, and a drain electrode. The source electrode and the drain electrode may not be fixed (that is, may be configured to not be fixed) and/or can be changed (that is, may be configured to be changed) based on a direction of a voltage and a current applied to the gate electrode, and thus, one of the source electrode and the drain electrode can be referred to as a first electrode, and the other can be referred to as a second electrode. The driving transistor DT and the switching transistor ST of each of the subpixels SP1 to SP4 can use at least one of a polysilicon semiconductor, an amorphous silicon semiconductor, and an oxide semiconductor, without being limited thereto. The driving transistor DT and the switching transistor ST can be a P type or an N type, or can be a combination of a P type and an N type.

The light emitting device ED can include an anode electrode connected to the driving transistor DT, a cathode electrode supplied with a second source voltage EVSS through a second power line VSSL, and an emission layer between the anode electrode and the cathode electrode. The anode electrode can be an independent electrode for each light emitting device, and the cathode electrode can be a common electrode which is shared by all light emitting devices, and a low-potential common voltage may be applied thereto. When a driving current is supplied from the driving transistor DT, an electron from the cathode electrode can be injected into the emission layer, a hole from the anode electrode can be injected into the emission layer, and a fluorescent or phosphorescent material can emit light, based on a recombination of the electron and the hole in the emission layer, and thus, the light emitting device ED can emit light having brightness proportional to a current value of the driving current.

For example, the anode electrode may be a pixel electrode, and the cathode electrode may be a common electrode, without being limited thereto. Conversely, the anode electrode may be a common electrode, and the cathode electrode may be a pixel electrode. Hereinafter, for convenience of description, it is assumed that the anode electrode is a pixel electrode and the cathode electrode is a common electrode.

The emission layer may include one or more of a hole injection layer (HIL), a hole transmitting layer (HTL), an electron transmitting layer (ETL) and an electron injection layer (EIL), but the present disclosure is not limited thereto.

In each of the subpixels SP1 to SP4, the driving transistor DT can be connected between the anode electrode of the light emitting device ED and a first power line VDDL which transfers a first source voltage EVDD. Here, the first source voltage EVDD can be applied to a first electrode of the driving transistor DT.

The driving transistor DT can be a transistor which drives the light emitting device ED and can be controlled based on a voltage applied to a gate electrode thereof to supply a current to the light emitting device ED. Accordingly, the light emitting device ED can be driven.

In each of the subpixels SP1 to SP4, a switching transistor ST can be connected between a first node N1 of the driving transistor DT and a data line DL. The switching transistor ST can be controlled by a scan signal Scan supplied through the scan line SCANL to apply a data voltage Vdata, supplied through the data line DL, to the first node N1. For example, the switching transistor ST can be turned on in response to the scan signal Scan supplied through the scan line SCANL to apply a data voltage Vdata to the first node N1.

In each of the subpixels SP1 to SP4, the capacitor Cst can be connected to the first node N1 and can be charged with a voltage applied to the first node N1. The capacitor Cst can supply a charged driving voltage to the driving transistor DT. The capacitor Cst can be a storage capacitor.

The compensation circuit CC can be provided for compensating for a threshold voltage of the driving transistor DT. The capacitor Cst can be connected between the first node N1 and the compensation circuit CC. The compensation circuit CC can be configured with one or more transistors. The compensation circuit CC can include one or more transistors and a capacitor and can be variously configured based on a compensation method. A pixel including the compensation circuit CC can have various structures such as 3T1C, 4T1C, 4T2C, 5T1C, 5T2C, 6T1C, 6T2C, 7T1C, and 7T2C, and so on.

Hereinafter, elements disposed in the non-transmissive area NTA and the transmissive area TA will be described in more detail with reference to FIG. 5.

Referring to FIG. 5, the display panel 110 according to an example embodiment of the present disclosure can include a first substrate 111 and a second substrate 112 facing each other, and a circuit device, a light emitting device ED, an encapsulation layer 180, a color filter CF, and a black matrix BM can be disposed between the first substrate 111 and the second substrate 112.

The circuit device can be disposed in each of subpixels SP1 to SP4 in the non-transmissive area NTA and can include various signal lines, a thin film transistor (TFT), and a capacitor. The signal lines can include pixel power lines, common power lines, scan lines, and data lines, and the TFT can include a switching transistor ST and a driving transistor DT. For example, the switching transistor ST can be turned on in response to the scan signal Scan supplied through the scan line SCANL to apply a data voltage Vdata to the first node N1 (see FIG. 4). The switching transistor can be turned on based on a scan signal supplied to a scan line and can charge a data voltage, supplied through the data line, in the capacitor.

The driving transistor DT can be turned on based on a data voltage charged in the capacitor Cst (see FIG. 4) and can generate a data current from power supplied through the pixel power line VDDL (see FIG. 4) to supply the data current to a first electrode E1 of each of the subpixels SP1 to SP4. The driving transistor DT can include an active layer ACT, a gate electrode GE, a source electrode SE, and a drain electrode DE.

In detail, a light blocking layer LS can be provided on the first substrate 111. For example, the light blocking layer LS can be provided on a portion of the first substrate 111. The light blocking layer LS can be provided to overlap a region where the driving transistor DT is formed and can block external light incident on the active layer ACT of the driving transistor DT. For example, the light blocking layer LS can be provided to overlap the driving transistor DT under the driving transistor DT. The display panel 110 including the transmissive area TA can be much used in an environment which is exposed at the outside instead of the inside thereof. A time for which the display panel 110 is exposed to external light can increase, and thus, a characteristic of a circuit device such as the transistor DT can be changed. Due to a change in characteristic of the circuit device, the display panel 110 can decrease in luminance, and a screen can be darkened.

In the display panel 110 according to an example embodiment of the present disclosure, the light blocking layer LS can be disposed under the driving transistor DT, and thus, can prevent external light from being incident on the driving transistor DT. The display panel 110 according to an example embodiment of the present disclosure can prevent the characteristic of the driving transistor DT from being changed, and subpixels can maintain high luminance.

The light blocking layer LS can be formed of a single layer or a multilayer including one of molybdenum (Mo), aluminum (Al), chrome (Cr), gold (Au), titanium (Ti), nickel (Ni), neodymium (Nd), and copper (Cu), or an alloy thereof, without being limited thereto.

A buffer layer 120 can be provided on the light blocking layer LS. For example, the buffer layer 120 can be provided on the light blocking layer LS and a portion of the first substrate 111. The buffer layer 120 can protect the transistors DT from water penetrating into the first substrate 111 vulnerable to water transmission. To this end, the buffer layer 120 can be included in the non-transmissive area NTA and the transmissive area TA. The buffer layer 120 can be formed of an inorganic layer, and for example, can be formed of silicon oxide (SiOx), silicon nitride (SiNx), or a multilayer thereof, without being limited thereto.

The active layer ACT of the driving transistor DT can be provided on the buffer layer 120. For example, the active layer ACT of the driving transistor DT can be provided on a portion of the buffer layer 120. The active layer ACT of the driving transistor DT can include a silicon-based semiconductor material or an oxide-based semiconductor material, without being limited thereto.

A gate insulation layer 130 can be provided on the active layer ACT of the driving transistor DT. The gate insulation layer 130 can be included in the non-transmissive area NTA and the transmissive area TA. The gate insulation layer 130 can be formed of an inorganic layer, and for example, can be formed of SiOx, SiNx, or a multilayer thereof without being limited thereto.

A gate electrode GE, a source electrode SE, and a drain electrode DE of the driving transistor DT can be provided on the gate insulation layer 130. The gate electrode GE, the source electrode SE, and the drain electrode DE of the driving transistor DT, as illustrated in FIG. 5, can be formed of the same material in the same layer, but are not limited thereto. In another embodiment, the source electrode SE and the drain electrode DE of the driving transistor DT can be formed of different materials in a layer which differs from the gate electrode GE. The source electrode SE and the drain electrode DE can be connected to the active layer ACT through a first contact hole CH1 passing through the gate insulation layer 130.

The gate electrode GE, the source electrode SE, and the drain electrode DE of the driving transistor DT can be formed of a single layer or a multilayer including one of Mo, Al, Cr, Au, Ti, Ni, Nd, and Cu, or an alloy thereof, without being limited thereto.

A first interlayer insulation layer 140 and a second interlayer insulation layer 150 can be provided on the gate electrode GE, the source electrode SE, and the drain electrode DE of the driving transistor DT. Specifically, the first interlayer insulation layer 140 can be provided on the gate electrode GE, the source electrode SE, and the drain electrode DE of the driving transistor DT, and the second interlayer insulation layer 150 can be provided on the first interlayer insulation layer 140. To increase a light transmittance of the transmissive area TA, the first interlayer insulation layer 140 and the second interlayer insulation layer 150 can be included in only the non-transmissive area NTA and may not be included (that is, may be configured to be not included) in the transmissive area TA. Each of the first interlayer insulation layer 140 and the second interlayer insulation layer 150 can be formed of an inorganic layer, and for example, can be formed of SiOx, SiNx, or a multilayer thereof, without being limited thereto.

A planarization layer 160 can be provided on the second interlayer insulation layer 150 so as to planarize a step height caused by the driving transistor DT. The planarization layer 160 can be configured to protect the driving transistor DT. The planarization layer 160 can be formed of an organic layer such as acryl resin, epoxy resin, phenolic resin, polyamide resin, or polyimide resin, without being limited thereto. The planarization layer 160 can be provided in the non-transmissive area NTA and may not be provided in at least a portion of the transmissive area TA. In the display panel 110 according to an example embodiment of the present disclosure, the planarization layer 160 may not be provided in the transmissive area TA, and thus, a light transmittance of the transmissive area TA can be enhanced.

Light emitting devices ED each including a first electrode E1, an emission layer EL, and a second electrode E2 and a bank 165 can be provided on the planarization layer 160. Each of the first electrode E1 and the second electrode E2 may comprise a metal material such as Au, W, Pt, Si, Ir, Ag, Cu, Ni, Ti, or Cr, and an alloy thereof. Alternatively, each of the first electrode E1 and the second electrode E2 may include a transparent conductive material such as ITO indium tin oxide or IZO indium zinc oxide.

The first electrode E1 can be provided on the planarization layer 160 and can be electrically connected to the driving transistor DT. In detail, the first electrode E1 can be connected to one of the source electrode SE and the drain electrode DE of the driving transistor DT through a second contact hole CH2 passing through the first interlayer insulation layer 140, the second interlayer insulation layer 150, and the planarization layer 160.

The first electrode E1 can be included in each of the subpixels SP1 to SP4 and may not be included in the transmissive area TA. The bank 165 can be provided between adjacent first electrodes E1, and thus, the adjacent first electrodes E1 can be electrically insulated from each other.

The first electrode E1 can include a metal material having a high reflectance such as a stack structure (Ti/Al/Ti) of aluminum and titanium, a stack structure (ITO/Al/ITO) of aluminum and indium tin oxide (ITO), an Ag alloy, a stack structure (ITO/Ag alloy/ITO) of Ag alloy and ITO, a MoTi alloy, and a stack structure (ITO/MoTi alloy/ITO) of MoTi alloy and ITO. The Ag alloy can be an alloy of Ag, palladium (Pd), and Cu. The MoTi alloy can be an alloy of Mo and Ti. The first electrode E1 can be an anode electrode, without being limited thereto.

The bank 165 can be provided on the planarization layer 160. Also, the bank 165 can be formed to cover an edge of the first electrode E1 and expose a portion of the first electrode E1. Accordingly, the bank 165 can solve a problem where emission efficiency is reduced because a current concentrates on an end of the first electrode E1.

The bank 165 can define an emission area EA of each of the subpixels SP1 to SP4. The emission area EA of each of the subpixels SP1 to SP4 can represent an area where the first electrode E1, the emission layer EL, and the second electrode E2 are sequentially stacked, and thus, a hole from the first electrode E1 and an electron from the second electrode E2 can be combined with each other in the emission layer EL to emit light. For example, an area where the bank 165 is formed cannot emit light (that is, may not emit light, or may be configured to not emit light) and can thus be a non-emission area NEA, and an area where the bank 165 is not formed and the first electrode E1 is exposed can be an emission area EA. The bank 165 can be provided in the non-transmissive area NTA and may be not provided in at least a portion of the transmissive area TA.

The bank 165 can be formed of an organic layer such as an acryl-based material, an epoxy-based material, a phenolic-based material, a polyamide-based material, or a polyimide-based material, without being limited thereto. Also, the bank 165 may contain carbon black, but is not limited thereto.

The emission layer EL can be disposed on the first electrode E1. The emission layer EL can include an emission material layer (EML) including a light emitting material. The light emitting material can include an organic material, an inorganic material, or a hybrid material. The emission layer EL can have a multi-layer structure. For example, the emission layer EL can further include at least one of a hole injection layer (HIL), a hole transport layer (HTL), an electron transport layer (ETL), and an electron injection layer (EIL). For example, when a voltage is applied to the first electrode E1 and the second electrode E2, a hole and an electron can respectively move to an emission material layer through a hole transport layer and an electron transport layer and can be combined with each other in the emission material layer to emit light.

In an example embodiment, the emission layer EL can be a common layer which is formed in the subpixels SP1 to SP4 in common. For example, the emission layer EL can be a white emission layer which emits white light. Here, the emission layer EL can be formed in a non-emission area NEA between the subpixels SP1 to SP4, in addition to the subpixels SP1 to SP4. The emission layer EL can be continuously formed in the subpixels SP1 to SP4 and between the subpixels SP1 to SP4. Also, the emission layer EL can be provided in the transmissive area TA as well as the non-transmissive area NTA including an emission areas EA and the non-emission area NEA, but is not limited thereto. Alternatively, the emission layer EL can be patterned and formed in only the non-transmissive area NTA including the emission area EA and the non-emission area NEA.

In another embodiment, in the emission layer EL, an emission material layer can be formed in each of the subpixels SP1 to SP4. A first emission layer emitting first light can be formed in the first subpixel SP1, a second emission layer emitting second light can be formed in the second subpixel SP2, a third emission layer emitting third light can be formed in the third subpixel SP3, and a fourth emission layer emitting fourth light can be formed in the fourth subpixel SP4. For example, a green emission layer emitting green light can be formed in the first subpixel SP1, a red emission layer emitting red light can be formed in the second subpixel SP2, a blue emission layer emitting blue light can be formed in the third subpixel SP3, and a white emission layer emitting white light can be formed in the fourth subpixel SP4, without being limited thereto. Other subpixels emitting light of a different color such as cyan, magenta, or yellow, etc. are also possible. For example, the emission material layer of the emission layer EL may not be formed in the transmissive area TA. A hole injection layer (HIL), a hole transport layer (HTL), an electron transport layer (ETL), and an electron injection layer (EIL) except the emission material layer can be formed in the subpixels SP1 to SP4 in common and can also be formed in the transmissive area TA.

The second electrode E2 can be disposed on the emission layer EL. The second electrode E2 can be a common layer which is formed in the subpixels SP1 to SP4 in common. The second electrode E2 can be formed in the non- emission area NEA between the subpixels SP1 to SP4, in addition to the emission area EA. The second electrode E2 can be continuously formed in the subpixels SP1 to SP4 and between the subpixels SP1 to SP4.

The second electrode E2 can include a transparent conductive material (TCO), such as ITO or indium zinc oxide (IZO) capable of transmitting light, or a semi-transmissive conductive material such as magnesium (Mg), Ag, or an alloy of Mg and Ag. In a case where the second electrode E2 includes a semi-transmissive conductive material, emission efficiency can be increased by a microcavity. The second electrode E2 can be a cathode electrode, without being limited thereto.

The encapsulation layer 180 can be provided on the light emitting devices ED. The encapsulation layer 180 can be formed on the second electrode E2 to cover the second electrode E2. The encapsulation layer 180 can prevent oxygen or water from penetrating into the emission layer EL and the second electrode E2. To this end, the encapsulation layer 180 can include at least one inorganic layer and at least one organic layer. The encapsulation layer 180 can be formed in a structure where an inorganic layer and an organic layer are alternately stacked, but is not limited thereto. For example, the encapsulation layer 180 may have a structure in which at least one organic layer is disposed between inorganic layers, but is not limited thereto.

A color filter CF can be provided on the encapsulation layer 180. The color filter CF can be patterned and formed in each of the subpixels SP1 to SP4. In detail, the color filter CF can include a plurality of color filters, such as a first color filter, a second color filter, a third color filter, and a fourth color filter. The first color filter can be disposed to correspond to the first subpixel SP1, and for example, can be a red color filter which transmits red light. The second color filter can be disposed to correspond to the second subpixel SP2, and for example, can be a green color filter which transmits green light. The third color filter can be disposed to correspond to the third subpixel SP3, and for example, can be a blue color filter which transmits blue light. The fourth color filter can be disposed to correspond to the fourth subpixel SP4, and for example, can be a white color filter which transmits white light. The white color filter can include a transparent organic material which transmits white light, but is not limited thereto.

A black matrix BM can be provided between color filters CF which are patterned and formed in each of the subpixels SP1 to SP4. The black matrix BM can be provided between the subpixels SP1 to SP4 and can prevent the occurrence of color mixture between adjacent subpixels SP1 to SP4. Also, the black matrix BM can prevent light incident from the outside from being reflected by a plurality of signal lines provided between the subpixels SP1 to SP4.

Moreover, the black matrix BM can be provided between the transmissive area TA and a plurality of subpixels SP1 to SP4 and can prevent light, emitted from each of the plurality of subpixels SP1 to SP4, from traveling to the transmissive area TA. The black matrix BM can include a material which absorbs light, and for example, can include a black dye which absorbs all light of a visible light wavelength band.

The first substrate 111 including the color filter CF and the black matrix BM can be bonded to the second substrate 112 by a separate adhesive layer 190. For example, the adhesive layer 190 can be an optically clear resin layer (OCR) or an optically clear adhesive film (OCA).

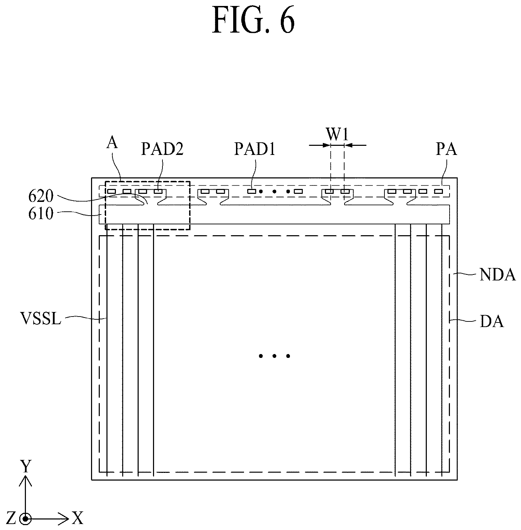

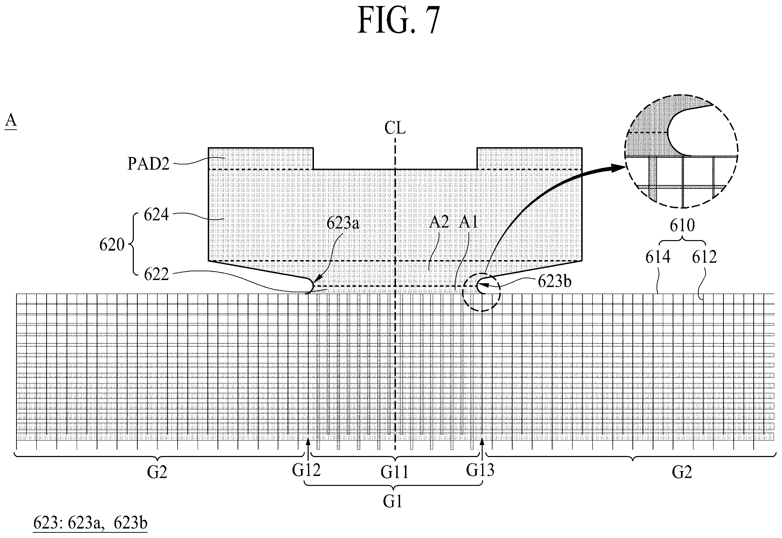

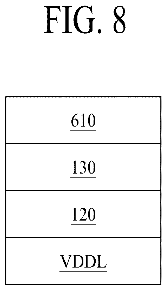

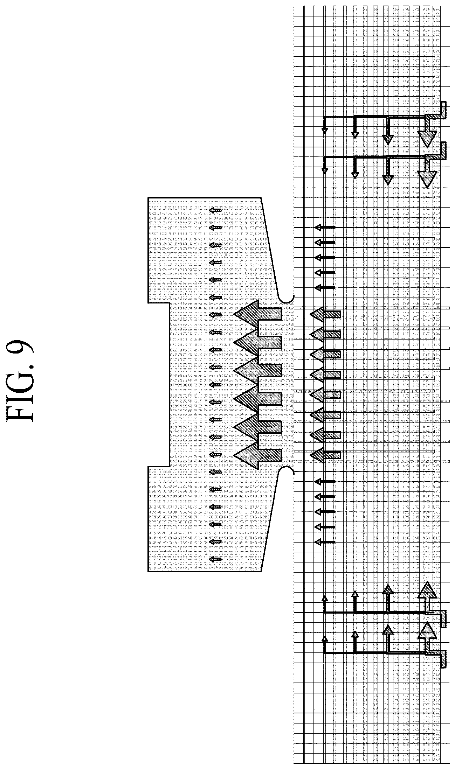

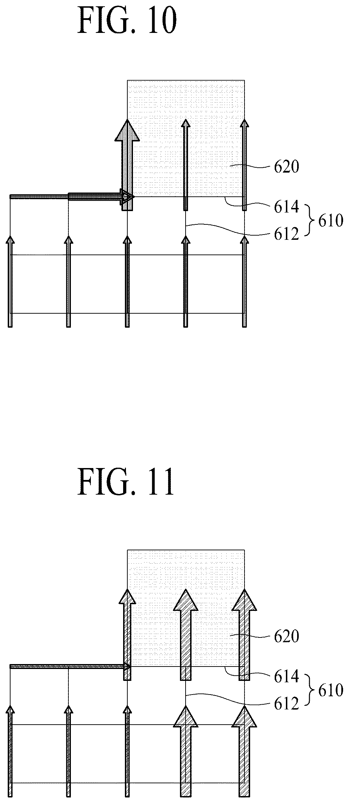

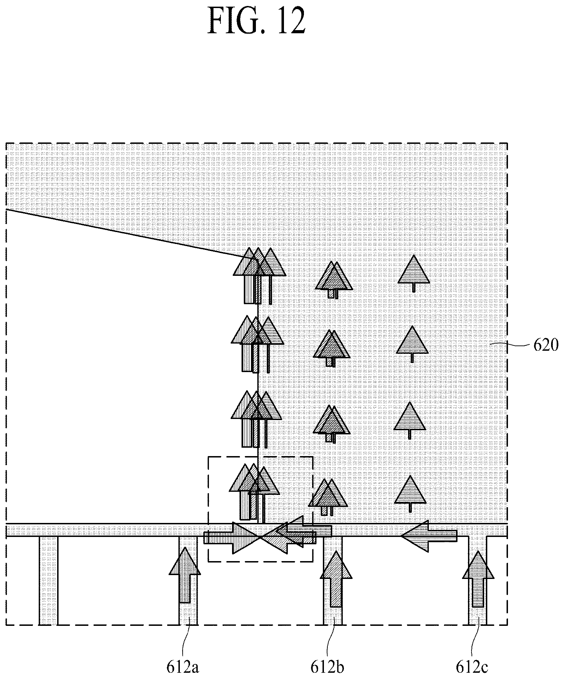

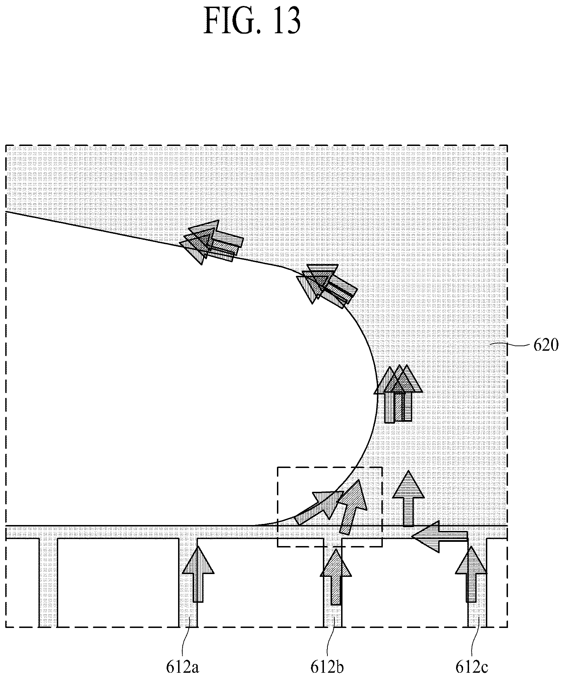

FIG. 6 is a plan view schematically illustrating a power shorting bar and a bottleneck portion according to an example embodiment of the present disclosure. FIG. 7 is an enlarged view of a region A of FIG. 6. FIG. 8 is a cross-sectional view illustrating an example of a stack structure of a power shorting bar and a pixel power line. FIG. 9 is a diagram illustrating a flow of a current in a power shorting bar and a pixel power line according to an example embodiment of the present disclosure. FIG. 10 is a diagram illustrating an example of a flow of a current when a first power line and a second power line have a certain width. FIG. 11 is a diagram illustrating an example of a flow of a current in a first power line and a second power line according to an example embodiment of the present disclosure. FIG. 12 is a diagram illustrating an example of a flow of a current when an inflow portion of a bottleneck portion has a certain width. FIG. 13 is a diagram illustrating an example of a flow of a current in an inflow portion of a bottleneck portion according to an example embodiment of the present disclosure.

A display panel 110 according to an example embodiment of the present disclosure, as illustrated in FIG. 6, can be divided into a display area DA where pixels are provided to display an image and a non-display area NDA which does not display an image. The non-display area NDA can include a pad area PA where power pads are disposed. The power pad can include a first power pad PAD1 to which a first source voltage (a high-level source voltage) EVDD is applied and a second power pad PAD2 to which a second source voltage (a low-level source voltage) EVSS is applied. A flexible film 220 (see FIG. 1) can be attached to the first power pad PAD1 and the second power pad PAD2 and can be supplied with the first source voltage (the high-level source voltage) EVDD and the second source voltage (the low-level source voltage) EVSS from the outside.

In the display panel 110 according to an example embodiment of the present disclosure, a power shorting bar 610 and a bottleneck portion 620 can be provided in the non-display area NDA.

The power shorting bar 610 can be disposed at one side of the display area DA, in the non-display area NDA. In detail, the power shorting bar 610 can be disposed at a side, where the pad area PA is disposed, of a plurality of sides of the display area DA. The power shorting bar 610 can be disposed between the display area DA and the pad area PA.

The power shorting bar 610 can extend long in a second direction (for example, an X-axis direction) between the display area DA and the pad area PA. The power shorting bar 610 can be connected to a plurality of common power lines VSSL provided in the display area DA and can supply the second source voltage (the low-level source voltage) EVSS to the plurality of common power lines VSSL.

The plurality of common power lines VSSL can extend in a first direction (for example, a Y-axis direction) in the display area DA. The plurality of common power lines VSSL can be disposed apart from one another in the non-transmissive area NTA (see FIG. 3). The plurality of common power lines VSSL can extend up to the non-display area NDA from the display area DA and can be connected to the power shorting bar 610 at one end thereof. The plurality of common power lines VSSL can be formed in the same layer as the power shorting bar 610, but are not limited thereto. The plurality of common power lines VSSL can be provided in a layer which differs from the power shorting bar 610, and for example, can be connected to the power shorting bar 610 through a contact hole at one end thereof.

The plurality of common power lines VSSL can be connected to a plurality of light emitting devices ED in the display area DA. The plurality of common power lines VSSL can transfer the second source voltage (the low-level source voltage) EVSS, supplied from the power shorting bar 610, to a cathode electrode E2 of each of the plurality of light emitting devices ED.

The bottleneck portion 620 can be disposed between the power shorting bar 610 and the second power pad PAD2 and can connect the power shorting bar 610 to the second power pad PAD2. The bottleneck portion 620 can contact the power shorting bar 610 at one side thereof and can contact the second power pad PAD2 at the other side thereof. The power shorting bar 610, the bottleneck portion 620, and the second power pad PAD2 can be formed of the same material in the same layer. That is, the power shorting bar 610, the bottleneck portion 620, and the second power pad PAD2 can be provided as one body, without being limited thereto.

The bottleneck portion 620 can be formed to have a first width W1 which is less than a width of the power shorting bar 610 and can be provided in plurality. Here, the first width W1 can represent a length of a side contacting the power shorting bar 610. The first width W1 can be a width in the second direction (for example, the X-axis direction). The plurality of bottleneck portions 620 can be disposed apart from one another. The plurality of bottleneck portions 620 can be respectively connected to a plurality of second power pads PAD2 and can receive the second source voltage (the low-level source voltage) EVSS through the plurality of second power pads PAD2 from the outside. The second source voltage (the low-level source voltage) EVSS can be applied to the power shorting bar 610 through the plurality of bottleneck portions 620 and can be applied to the plurality of common power lines VSSL of the display area DA through the power shorting bar 610. The plurality of common power lines VSSL can transfer the second source voltage (the low-level source voltage) EVSS, supplied from the power shorting bar 610, to a cathode electrode E2 of each of the plurality of light emitting devices ED.

As described above, when the second source voltage (the low-level source voltage) EVSS is applied to the power shorting bar 610 and the bottleneck portion 620, a current can flow from the power shorting bar 610 to the bottleneck portion 620. For example, because the bottleneck portion 620 has the first width W1 which is less than the power shorting bar 610, a current can concentrate in a partial region of the bottleneck portion 620. The bottleneck portion 620 can be damaged because much heat occurs in a region where a current concentrates.

In the display panel 110 according to an example embodiment of the present disclosure, the power shorting bar 610 can be formed in a mesh structure, a concentration of a current in the bottleneck portion 620 can be reduced.

In detail, as illustrated in FIG. 7, the power shorting bar 610 can have a mesh structure where the plurality of first power lines 612 extending in the first direction (for example, the Y-axis direction) are connected to the plurality of second power lines 614 extending in the second direction (for example, the X-axis direction). The plurality of first power lines 612 and the plurality of second power lines 614 can be provided as one body in the same layer. The plurality of first power lines 612 and the plurality of second power lines 614 can be formed of the same material in the same layer as a gate electrode GE (see FIG. 5) of a driving transistor DT (see FIG. 5).

The plurality of first power lines 612 can extend in the first direction (for example, the Y-axis direction) between the pad area PA and the display area DA and can be disposed apart from one another in the second direction (for example, the X-axis direction). Some of the plurality of first power lines 612 can contact the bottleneck portion 620, and the other first power lines 612 may not contact the bottleneck portion 620. The plurality of first power lines 612 can be grouped into a first group G1 which contacts the bottleneck portion 620 at one end thereof and a second group G2 which does not contact the bottleneck portion 620 at one end thereof. First power lines 612 included in the second group G2 can be disposed apart from the bottleneck portion 620. That is, the first power lines 612 included in the first group G1 can contact the bottleneck portion 620 at one end thereof, and the first power lines 612 included in the second group G2 do not contact the bottleneck portion 620 at one end thereof.

The first power lines 612 included in the second group G2 can have a width which differs from that of at least one of first power lines 612 included in the first group G1. The first power lines 612 included in the second group G2 can have a width which is less than that of at least one of the first power lines 612 included in the first group G1. At least one of the first power lines 612 included in the first group G1 can have a second width. First power lines 612, disposed in a region except an edge region, of the first power lines 612 included in the first group G1 can have the second width. The first power lines 612 included in the second group G2 can have a third width which is less than the second width. That is, first power lines 612, which do not contact the bottleneck portion 620, of the plurality of first power lines 612 can be formed to be relatively thin. On the other hand, most first power lines 612, contacting the bottleneck portion 620, of the plurality of first power lines 612 can be formed to be relatively thick.

A resistance can be inversely proportional to a cross-sectional area, and thus, in the first power lines 612, a resistance can decrease when a cross-sectional area is large, and a resistance can increase when a cross-sectional area is small. Most first power lines 612, contacting the bottleneck portion 620, of the plurality of first power lines 612 can have the second width which is relatively large, and thus, a cross-sectional area can be formed to be large, and a resistance can decrease. A current can be inversely proportional to a resistance, and thus, as illustrated in FIG. 9, a relatively high amount of current can flow in the first power lines 612 included in the first group G1.

On the other hand, first power lines 612, which do not contact the bottleneck portion 620, of the plurality of first power lines 612 can have the third width which is small, and thus, a cross-sectional area can be formed to be small, and a resistance can increase. Accordingly, as illustrated in FIG. 9, a relatively lower amount of current can flow in the first power lines 612 included in the second group G2 than the first power lines 612 included in the first group G1.

Furthermore, at least some of the first power lines 612 included in the first group G1 can have a width which differs from that of the other first power lines 612 included in the first group G1. That is, the first power lines 612 included in the first group G1 can have different widths. In detail, the first power lines 612 included in the first group G1 can be grouped into a first subgroup G11 provided in a first area, a second subgroup G12 provided in a second area disposed at one side of the first area, and a third subgroup G13 provided in a third region disposed at the other side of the first area.

The second subgroup G12 can include a first power line 612, disposed at a left outermost portion, of the first power lines 612 included in the first group G1. The second subgroup G12 can include only one first power line 612, disposed at the left outermost portion, of the first power lines 612 included in the first group G1, but is not limited thereto. The second subgroup G12 can include a plurality of first power lines 612, provided in a left edge region, of the first power lines 612 included in the first group G1.

The third subgroup G13 can include a first power line 612, disposed at a right outermost portion, of the first power lines 612 included in the first group G1. The third subgroup G13 can include only one first power line 612, disposed at the right outermost portion, of the first power lines 612 included in the first group G1, but is not limited thereto. The third subgroup G13 can include a plurality of first power lines 612, provided in a right edge region, of the first power lines 612 included in the first group G1.

The first power lines 612 included in the first subgroup G11 can have a width which differs from that of the first power lines 612 included in the second subgroup G12 and the third subgroup G13. The first power lines 612 included in the second subgroup G12 and the third subgroup G13 can have a width which is less than that of the first power lines 612 included in the first subgroup G11.

The first power lines 612 included in the first subgroup G11 can have the second width. The first power lines 612 included in the second subgroup G12 and the third subgroup G13 can have a fourth width which is less than the second width. In an example embodiment, the first power lines 612 included in the second subgroup G12 and the third subgroup G13 can have the same width as that of the first power lines 612 included in the second group G2. That is, the fourth width of the first power lines 612 included in the second subgroup G12 and the third subgroup G13 can be equal to the third width of the first power lines 612 included in the second group G2. That is, the first power lines 612 included in the first subgroup G11 can have a width which is greater than a width of the first power lines 612 included in the second subgroup G12, the third subgroup G13 and the second group G2.

The plurality of second power lines 614 can extend in the second direction (for example, the X-axis direction) between the pad area PA and the display area DA and can be disposed apart from one another in the first direction (for example, the Y-axis direction). A partial region of an uppermost second power line 614 of the plurality of second power lines 614 can contact the bottleneck portion 620, and the other partial region may not contact the bottleneck portion 620.

Some of the plurality of second power lines 614 can have a width which differs from that of the other second power lines 614. A second power line 614 having a first separation distance from the bottleneck portion 620 can have a width which differs from that of a second power line 614 having a second separation distance from the bottleneck portion 620. The first separation distance can be less than the second separation distance. For example, the second power line 614 having the first separation distance from the bottleneck portion 620 can have a fifth width. The second power line 614 having the second separation distance from the bottleneck portion 620 can have a sixth width which is greater than the fifth width. That is, a second power line 614 disposed close to the bottleneck portion 620 can be formed to be thinner than a second power line 614 disposed far away from the bottleneck portion 620.

The second power line 614 disposed close to the bottleneck portion 620 can have the fifth width which is small, and thus, a cross-sectional area can be formed to be small, and a resistance can increase. Accordingly, as illustrated in FIG. 9, a relatively low amount of current can flow in the second power line 614 disposed close to the bottleneck portion 620.

On the other hand, the second power line 614 disposed far away from the bottleneck portion 620 can have the sixth width which is relatively large, and thus, a cross-sectional area can be formed to be large, and a resistance can decrease. A current can be inversely proportional to a resistance, and thus, as illustrated in FIG. 9, a relatively higher amount of current can flow in the second power line 614 disposed far away from the bottleneck portion 620 than the second power line 614 disposed close to the bottleneck portion 620.

In an example embodiment, as illustrated in FIG. 7, a width of the plurality of second power lines 614 can increase progressively in a direction distancing from the bottleneck portion 620. For example, in the plurality of second power lines 614, the amount of current can increase progressively in a direction distancing from the bottleneck portion 620.

In the display panel 110 according to an example embodiment of the present disclosure, the power shorting bar 610 can be formed in a mesh structure which is configured with the plurality of first power lines 612 and the plurality of second power lines 614, and widths of the plurality of first power lines 612 and the plurality of second power lines 614 can be differently designed.

In the display panel 110 according to an example embodiment of the present disclosure, widths of the plurality of first power lines 612 can be differently designed. In detail, in the display panel 110 according to an example embodiment of the present disclosure, first power lines 612, which do not contact the bottleneck portion 620, of the plurality of first power lines 612 can be formed to be thin, thereby inducing a relatively low amount of current to flow in the first power lines 612 which do not contact the bottleneck portion 620.

Moreover, in the display panel 110 according to an example embodiment of the present disclosure, a first power line 612 disposed at an outermost portion among first power lines 612 contacting the bottleneck portion 620 can be formed to be thin. A current flowing in first power lines 612 which do not contact the bottleneck portion 620 can flow through the second power line 614 into the first power lines 612 contacting the bottleneck portion 620. For example, when the first power lines 612 contacting the bottleneck portion 620 have the same thickness, as illustrated in FIG. 10, a current can concentrate in a first power line 612 disposed at an outermost portion having a shortest distance.

In the display panel 110 according to an example embodiment of the present disclosure, a first power line 612 disposed at an outermost among first power lines 612 contacting the bottleneck portion 620 can be formed to be relatively thin, thereby preventing a current from concentrating in the first power line 612 disposed at the outermost portion. In the display panel 110 according to an example embodiment of the present disclosure, first power lines 612 disposed in a center region among the first power lines 612 contacting the bottleneck portion 620 can be formed to be relatively thick, thereby inducing a current to flow to the first power lines 612 disposed in the center region.

Moreover, in the display panel 110 according to an example embodiment of the present disclosure, widths of the plurality of second power lines 614 can be differently designed. In detail, in the display panel 110 according to an example embodiment of the present disclosure, second power lines 614 disposed close to the bottleneck portion 620 among the plurality of second power lines 614 can be formed to be thin, and second power lines 614 disposed far away from the bottleneck portion 620 can be formed to be thick. Therefore, the display panel 110 according to an example embodiment of the present disclosure can induce a relatively low amount of current to flow in the second power lines 614 disposed close to the bottleneck portion 620 and can induce a relatively high amount of current to flow in the second power lines 614 disposed far away from the bottleneck portion 620.

In the display panel 110 according to an example embodiment of the present disclosure, because widths of the plurality of first power lines 612 and the plurality of second power lines 614 are differently designed as described above, a current flowing from the plurality of first power lines 612 and the plurality of second power lines 614 to the bottleneck portion 620 can be dispersed as illustrated in FIG. 11.

A current can flow to a portion having a shortest distance in the same resistance. Therefore, in a case where widths of the plurality of first power lines 612 and the plurality of second power lines 614 are designed to be constant, as illustrated in FIG. 10, a current flowing through power lines 612 and 614 which do not contact the bottleneck portion 620 can flow into an edge region of the bottleneck portion 620 at a shortest distance. Accordingly, a concentration of a current in the edge region of the bottleneck portion 620 can occur.

On the other hand, in the display panel 110 according to an example embodiment of the present disclosure, widths of the plurality of first power lines 612 and the plurality of second power lines 614 can be differently designed, and thus, the plurality of first power lines 612 and the plurality of second power lines 614 can have different resistances. In the display panel 110 according to an example embodiment of the present disclosure, first power lines 612 contacting a center region of the bottleneck portion 620 and second power lines 614 disposed far away from the bottleneck portion 620 can have a small resistance, as illustrated in FIG. 11, thereby inducing a relatively high amount of current among currents, flowing from the common power lines VSSL to the power shorting bar 610, to be dispersed in the center region of the bottleneck portion 620 and flow. Accordingly, in the display panel 110 according to an example embodiment of the present disclosure, a concentration of a current in the edge region of the bottleneck portion 620 can be reduced.

Furthermore, in the display panel 110 according to an example embodiment of the present disclosure, because the power shorting bar 610 is formed in a mesh structure, a metal stress can be reduced compared to a case where the power shorting bar 610 is provided as a common electrode. The power shorting bar 610 can overlap the pixel power line VDDL in at least a partial region. The pixel power line VDDL can extend up to the pad area PA of the non-display area NDA from the display area DA and can be connected to the first power pad PAD1. The pixel power line VDDL can transfer the first source voltage (the high-level source voltage) EVDD, supplied from the first power pad PAD1, to the anode electrode E1 of each of the plurality of light emitting devices ED disposed in the display area DA. The pixel power line VDDL can overlap the power shorting bar 610 in at least a partial region. For example, the pixel power line VDDL and the power shorting bar 610 can have a stack structure as illustrated in FIG. 8. The power shorting bar 610 can be formed of the same material in the same layer as a gate electrode GE (see FIG. 5) of a driving transistor DT (see FIG. 5). Also, the pixel power line VDDL can be formed of the same material in the same layer as a light blocking layer LS (see FIG. 5). For example, a gate insulation layer 130 and a buffer layer 120 can be provided between the power shorting bar 610 and the pixel power line VDDL and can insulate the power shorting bar 610 from the pixel power line VDDL.

When the power shorting bar 610 is provided as a surface-shaped electrode, a metal stress caused by the power shorting bar 610 can increase, and due to this, there can be a limitation in reducing a thickness of insulation layers between the power shorting bar 610 and the pixel power line VDDL. When a thickness of the insulation layers between the power shorting bar 610 and the pixel power line VDDL is formed to be thin, peripheral insulation layers as well as the power shorting bar 610 and the pixel power line VDDL can be damaged due to a metal stress. In the display panel 110 according to an example embodiment of the present disclosure, because the power shorting bar 610 is formed in a mesh structure, a metal stress caused by the power shorting bar 610 can decrease, and moreover, the occurrence of damage caused by the metal stress can be prevented. Also, in the display panel 110 according to an example embodiment of the present disclosure, a thickness of the insulation layers between the power shorting bar 610 and the pixel power line VDDL can decrease, and thus, a total thickness of the display panel 110 can be reduced.

Moreover, in the display panel 110 according to an example embodiment of the present disclosure, because the power shorting bar 610 has a mesh structure, an area where the power shorting bar 610 overlaps the pixel power line VDDL can be reduced, and thus, the occurrence of a static electricity burst phenomenon can be prevented between the power shorting bar 610 and the pixel power line VDDL.

The bottleneck portion 620 can be disposed between the power shorting bar 610 and the second power pad PAD2 and can connect the power shorting bar 610 to the second power pad PAD2. The bottleneck portion 620 can contact the power shorting bar 610 at one side thereof and can contact the second power pad PAD2 at the other side thereof. The bottleneck portion 620 can be provided in plurality, and the plurality of bottleneck portions 620 can be disposed apart from one another in the second direction (for example, the X-axis direction).

Each of the plurality of bottleneck portions 620 can include an inflow portion 622 which contacts the power shorting bar 610 to allow a current to flow in through the inflow portion 622 and a connection portion 624 which is connected to the second power pad PAD2.

The inflow portion 622 can contact the power shorting bar 610 at one side thereof. The inflow portion 622 can contact some of the plurality of first power lines 612, and a current can flow in from the some first power lines 612 contacting the inflow portion 622. Also, the inflow portion 622 can contact a partial region of an uppermost second power line 614 of the plurality of second power lines 614, and a current can flow in from the uppermost second power line 614 contacting the inflow portion 622.

The inflow portion 622 can include a concave portion 623 which is concavely formed at at least one side thereof to face a center line CL. The inflow portion 622 can include the concave portion 623 which is provided at at least one side thereof and between a side contacting the power shorting bar 610 and a side contacting the connection portion 624.

For example, the inflow portion 622 can include a first concave portion 623a which is concavely formed at a left edge thereof to face the center line CL and a second concave portion 623b which is concavely formed at a right edge thereof to face the center line CL. The first concave portion 623a and the second concave portion 623b can be round formed in a streamlined shape or a curved shape. For example, the first concave portion 623a and the second concave portion 623b can have a semicircular shape.

As the concave portion 623 is formed at at least one side of the inflow portion 622, the inflow portion 622 can include a first area A1 where a width decreases progressively toward the second power pad PAD2 from a side contacting the power shorting bar 610. In an example embodiment, the inflow portion 622 can further include a second area A2 where a width increases progressively toward the second power pad PAD2 from the first area A1.

In the display panel 110 according to an example embodiment of the present disclosure, a width of the inflow portion 622 may be not constant (in other words, in the embodiment, a width of the inflow portion 622 is not constant), and the display panel 110 can include the first area A1 where a width decreases progressively toward the second power pad PAD2 from a side contacting the power shorting bar 610, and thus, can disperse a current which flows into an edge region of the inflow portion 622. To provide a detailed description, as in FIG. 12, the inflow portion 622 of the bottleneck portion 620 can have a constant width. That is, the inflow portion 622 of the bottleneck portion 620 can vertically or perpendicularly contact the power shorting bar 610. For example, the inflow portion 622 of the bottleneck portion 620 can be perpendicular to the second power line 614 of the power shorting bar 610. For example, a current flowing into the inflow portion 622 can concentrate in an edge of the inflow portion 622.

To provide description for example, a current flowing in through the first power line 612a which does not contact the inflow portion 622 of the bottleneck portion 620 can flow along a path having a shortest distance up to the second power pad PAD2. Therefore, a current flowing in through the first power line 612a which does not contact the inflow portion 622 of the bottleneck portion 620 can flow to the connection portion 624 along the concave portion 623 or the edge of the inflow portion 622.

Moreover, a current flowing in through at least one first power lines 612b and 612c disposed in an edge region among first power lines 612 contacting the inflow portion 622 of the bottleneck portion 620 can flow in a direction in which a straight line is formed with respect to the first power lines 612b and 612c. Also, because the inflow portion 622 is perpendicular to the power shorting bar 610, a first path where a current flowing in through the first power lines 612b and 612c flows to an end of a side at which the inflow portion 622 contacts the power shorting bar 610 and then flows along an edge of the inflow portion 622 can have the same distance as a second path where a current flows in a direction in which a straight line is formed with respect to the first power lines 612b and 612c. Therefore, a portion of a current flowing in through the at least one first power lines 612b and 612c disposed in the edge region among the first power lines 612 contacting the inflow portion 622 of the bottleneck portion 620 can flow along the second path, and the other portion can flow along the first path as illustrated in FIG. 12. Accordingly, a higher amount of current can concentrate in an edge (particularly, an end of a side at which the inflow portion 622 contacts the power shorting bar 610) than a center region of the inflow portion 622, and thus, a temperature can increase, and the inflow portion 622 can be damaged.

Furthermore, because the concave portion 623 having a streamlined shape or a curved shape is formed in the inflow portion 622 of the bottleneck portion 620, the display panel 110 according to an example embodiment of the present disclosure can disperse a current in the edge region of the inflow portion 622.

To provide description for example, a current flowing in through a first power line 612a which does not contact the inflow portion 622 of the bottleneck portion 620 can flow along a path having a shortest distance up to the second power pad PAD2, and thus, can flow to the connection portion 624 along the edge of the inflow portion 622. However, a curved concave portion 623 can be provided in the inflow portion 622 according to an example embodiment of the present disclosure. Therefore, the first path where a current flowing in through the first power lines 612b and 612c flows to the end of the side at which the inflow portion 622 contacts the power shorting bar 610 and then flows along the edge of the inflow portion 622 can more increase than the second path where a current flows in a direction in which a straight line is formed with respect to the first power lines 612b and 612c. Accordingly, a current flowing in through at least one first power lines 612b and 612c disposed in an edge region among first power lines 612 contacting the inflow portion 622 of the bottleneck portion 620 can flow to the second path instead of the first path. As a result, a current cannot concentrate in the end of the side at which the inflow portion 622 contacts the power shorting bar 610 and can be dispersed.

According to example embodiments of the disclosure, there may be provided a display device including: a display area where a plurality of pixels are disposed to display an image, a non-display area disposed outside the display area, the non-display area including a pad area, a power shorting bar disposed at one side of the display area, in the non-display area, a power pad disposed in the pad area, and a bottleneck portion connecting the power shorting bar to a power pad. The power shorting bar has a mesh structure where a plurality of first power lines extending in a first direction and a plurality of second power lines extending in a second direction are connected to each other.

In the present disclosure, a power shorting bar can be formed in a mesh structure which is configured with a plurality of first power lines and a plurality of second power lines, and widths of the plurality of first power lines and the plurality of second power lines can be differently designed, thereby decreasing a concentration of a current in an edge region of a bottleneck portion.

Moreover, in the present disclosure, a metal stress can be reduced compared to a case when the power shorting bar is provided as a surface-shaped electrode, thereby preventing the occurrence of damage caused by the metal stress.

Moreover, in the present disclosure, a thickness of insulation layers between the power shorting bar and a pixel power line can decrease, and thus, a total thickness of a display panel can also be reduced.

Moreover, in the present disclosure, the occurrence of a static electricity burst phenomenon can be prevented between the power shorting bar and the pixel power line.

Moreover, in the present disclosure, a concave portion having a streamlined shape or a curved shape can be formed in an inflow portion of the bottleneck portion, and thus, a current can be dispersed in the edge region of the inflow portion.

Moreover, as a defect rate of the power shorting bar is reduced, the present disclosure can decrease the manufacturing process cost and can shorten a manufacturing process time, and moreover, can reduce production energy. Also, the present disclosure can reduce the occurrence of a greenhouse gas caused by a manufacturing process and can thus implement environment/social/governance (ESG).

## Claims

1. A display device, comprising:
a display area (DA) where a plurality of pixels are disposed to display an image;
a non-display area (NDA) disposed outside the display area (DA), the non-display area (NDA) including a pad area (PA);
a power shorting bar (610) disposed at one side of the display area (DA), in the non-display area (NDA);
a power pad (PAD2) disposed in the pad area (PA); and
a bottleneck portion (620) connecting the power shorting bar (610) to the power pad (PAD2),
wherein the power shorting bar (610) has a mesh structure where a plurality of first power lines (612) extending in a first direction (Y) and a plurality of second power lines (614) extending in a second direction (X) are connected to each other.

2. The display device of claim 1, wherein the plurality of second power lines (614) have different widths, and/or wherein the plurality of second power lines (614) have a width which increases progressively in a direction of increasing distance from the bottleneck portion (620).

3. The display device of claim 1 or 2, wherein the bottleneck portion (620) contacts some of the plurality of first power lines (612) and does not contact the other first power lines (612).

4. The display device of any one of the preceding claims, wherein the plurality of first power lines (612) are grouped into a first group (G1) which contacts the bottleneck portion (620) at one end of the first group (G1) and a second group (G2) which does not contact the bottleneck portion (620) at one end of the second group (G2), and
wherein each of first power lines (612) included in the second group (G2) has a width which differs from a width of at least one of first power lines (612) included in the first group (G1), and/or wherein each of the first power lines (612) included in the second group (G2) has a width which is less than a width of at least one of the first power lines (612) included in the first group (G1).

5. The display device of claim 4, wherein the first power lines (612) included in the first group (G1) are grouped into a first subgroup (G11) provided in a first area, a second subgroup (G12) provided in a second area disposed at one side of the first area, and a third subgroup (G13) provided in a third area disposed at the other side of the first area, and
wherein each of first power lines (612) included in the first subgroup (G11) has a width which differs from a width of each of first power lines (612) included in the second subgroup (G12) and the third subgroup (G13).

6. The display device of claim 5, wherein the second subgroup (G12) comprises a first power line (612b), disposed at a left outermost portion, of the first power lines (612) included in the first group (G1), and the third subgroup (G13) comprises a first power line (612), disposed at a right outermost portion, of the first power lines (612) included in the first group (G1).

7. The display device of claim 5 or 6, wherein each of the first power lines (612) included in the first subgroup (G1 1) has a width which is greater than a width of each of the first power lines (612) included in the second subgroup (G12) and the third subgroup (G13), and/or wherein each of the first power lines (612) included in the second subgroup (G12) and the third subgroup (G13) has a same width as a width of each of the first power lines (612) included in the second group (G2).

8. The display device of any one of the preceding claims, wherein the bottleneck portion (620) comprises an inflow portion (622) contacting the power shorting bar (610) and configured to allow a current to flow in through the inflow portion (622).

9. The display device of claim 8, wherein the inflow portion (622) contacts some of the plurality of first power lines (612) and is configured to allow a current to flow in from the first power lines (612) contacting the inflow portion (622),
and/or wherein the inflow portion (622) contacts a partial region of an uppermost second power line (614) of the plurality of second power lines (614) and is configured to allow a current to flow in from the uppermost second power line (614) contacting the inflow portion (622).

10. The display device of claim 8 or 9, wherein the inflow portion (622) comprises a region (A1) where a width decreases progressively toward the power pad (PAD2) from a side contacting the power shorting bar (610), and/or wherein the inflow portion (622) comprises a concave portion (623a; 623b) concavely formed at at least one side of the inflow portion with respect to a center line (CL) of the bottleneck portion (620).

11. The display device of claim 10, wherein the concave portion (623a; 623b) comprises a streamlined shape or a curved shape.

12. The display device of any one of the preceding claims, further comprising a plurality of common power lines (VSSL) extending in the first direction (Y) up to the non-display area (NDA) from the display area (DA), one end of each of the plurality of common power lines (VSSL) being connected to the power shorting bar (610).

13. The display device of claim 12, wherein the display area (DA) comprises transmissive areas (TA) configured for transmitting external light and a non-transmissive area (NTA) between adjacent transmissive areas (TA), and
each of the plurality of common power lines (VSSL) is disposed in the non-transmissive area (NTA).

14. The display device of claim 12 or 13, further comprising a light emitting device (ED) including an anode electrode (E1), an emission layer (EL), and a cathode electrode (E2), the light emitting device (ED) being provided in the non-transmissive area (NTA), and
each of the plurality of common power lines (VSSL) is configured for transferring a source voltage to the cathode electrode (E2) of the light emitting device (ED).

15. The display device of claim 12, 13, or 14, wherein the plurality of common power lines (VSSL) is provided in a layer which differs from the plurality of first power lines (612) of the power shorting bar (610), and
wherein each of the plurality of common power lines (VSSL) is connected to a corresponding first power line (612) of the plurality of first power lines (612) of the power shorting bar (610) through a contact hole.
